# EUROPEAN PATENT APPLICATION

(11) **EP 4 651 136 A1**
(43) Date of publication of application: **19.11.2025**
(21) Application number: 25176950.1
(22) Date of filing: 16.05.2025
(51) Int. Cl.: G11C 5/14, G11C 11/16

(54) **ARRAY ARCHITECTURE FOR DISTRIBUTED MRAM**

(30) Priority: 17.05.2024 US 202463648790 P; 14.05.2025 US 202519207960
(71) Applicant: Everspin Technologies, Inc., Chandler, Arizona 85226 (US)
(72) Inventor: SADD, Michael A., Chandler, AZ, 85226 (US); WILLIAMS, Jacob T., Chandler, AZ, 85226 (US); ALAM, Syed M., Chandler, AZ, 85226 (US)
(74) Representative: Eisenführ Speiser

(57) **Abstract**

A memory device including an array circuit including a magnetic tunnel junction (MTJ) bit having a logical state and including a set of MTJs is provided. The memory device further includes a read device electrically connected to the MTJ bit and configured to read the logical state of the MTJ bit. The memory device includes a write circuit electrically connected to the MTJ bit and configured to write the logical state of the MTJ bit. The array circuit is powered off between operations on the MTJ bit by the read device and/or the write circuit.

## Description

### CROSS-REFERENCE TO RELATED APPLICATION

This application claims benefit to U.S. Provisional Patent Application No. 63/648,790, filed May 17, 2024, the entire contents of which are incorporated herein by reference.

### TECHNICAL FIELD

Embodiments of the present disclosure relate generally to systems and methods for a memory device, and, more particularly, memory devices with shared read and/or write devices.

### INTRODUCTION

Each integrated circuit chip may include billions of devices thereon, including memory devices such as magnetoresistive tunnel junctions (MTJs). To increase speed and performance, it is desirable to include more devices on each integrated circuit chip. However, some memory architectures occupy more layout area than others on each integrated circuit chip. Therefore, it is desirable to have a memory device that is more area-efficient so that more devices may be included on each integrated circuit chip.

### SUMMARY

Various aspects discussed herein may include a memory device, which may include: an array circuit including a magnetic tunnel junction (MTJ) bit having a logical state, the array circuit including a set of MTJs; a first read device electrically connected to the MTJ bit and configured to read the logical state of the MTJ bit; and a write circuit electrically connected to the MTJ bit, the write circuit configured to write the logical state of the MTJ bit, wherein the array circuit is powered off between operations on the MTJ bit by the first read device, the write circuit, or both the first read device and the write circuit.

Various aspects discussed herein may include a memory device, which may include: an array circuit including a magnetic tunnel junction (MTJ) bit having a logical state, the MTJ bit including a first array of at least two MTJs having a first polarity and a second array of at least two MTJs having a second polarity opposite the first polarity; a read device configured to read the first polarity of the at least two MTJs of the first array, the read device configured to read the second polarity of the at least two MTJs of the second array; and a write circuit electrically connected to the MTJ bit, wherein the write circuit is configured to write the MTJs in the first array and the second array, wherein the array circuit is configured to be powered off between read operations on the MTJ bit by the read device.

Various aspects discussed herein may include a memory device, which may include: an array circuit including a magnetic tunnel junction (MTJ) bit having a logical state, the MTJ bit including: a first MTJ array; a second MTJ array; a third MTJ array; and a fourth MTJ array, wherein the first and second MTJ arrays have a first polarity and the third and fourth MTJ arrays have a second polarity opposite the first polarity; a read circuit electrically connected to the MTJ bit and configured to read the logical state of the MTJ bit; and a write circuit electrically connected to the MTJ bit, wherein the array circuit is configured to be powered off between read operations on the MTJ bit by the read device.

### BRIEF DESCRIPTION OF THE DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIG. 1 depicts a diagram of a magnetic tunnel junction (MTJ), according to various embodiment of the present disclosure.
FIG. 2 depicts a diagram of a memory device.
FIG. 3A depicts a functional diagram of a memory device, according to a first exemplary embodiment of the present disclosure.
FIG. 3B depicts a table showing the electrical configuration of the exemplary memory device shown in FIG. 3A for read and write operations, according to the first exemplary embodiment of the present disclosure.
FIG. 4A depicts a functional diagram of a memory device, according to a second exemplary embodiment of the present disclosure.
FIG. 4B depicts a table showing the electrical configuration of the exemplary memory device shown in FIG. 4A for read and write operations, according to the second exemplary embodiment of the present disclosure.
FIG. 5A depicts a functional diagram of a memory device, according to a third exemplary embodiment of the present disclosure.
FIG. 5B depicts a table showing the electrical configuration of the exemplary memory device shown in FIG. 5A for read and write operations, according to the third exemplary embodiment of the present disclosure.
FIG. 6A depicts a functional diagram of a memory device, according to a fourth exemplary embodiment of the present disclosure.
FIG. 6B depicts a table showing the electrical configuration of the exemplary memory device shown in FIG. 6A for read and write operations, according to the fourth exemplary embodiment of the present disclosure.
FIG. 7A depicts a functional diagram of a memory device, according to a fifth exemplary embodiment of the present disclosure.
FIG. 7B depicts a table showing the electrical configuration of the exemplary memory device shown in FIG. 7A for read and write operations, according to the fifth exemplary embodiment of the present disclosure.
FIG. 8A depicts a functional diagram of a memory device, according to a sixth exemplary embodiment of the present disclosure.
FIG. 8B depicts a table showing the electrical configuration of the exemplary memory device shown in FIG. 8A for read and write operations, according to the sixth exemplary embodiment of the present disclosure.

There are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

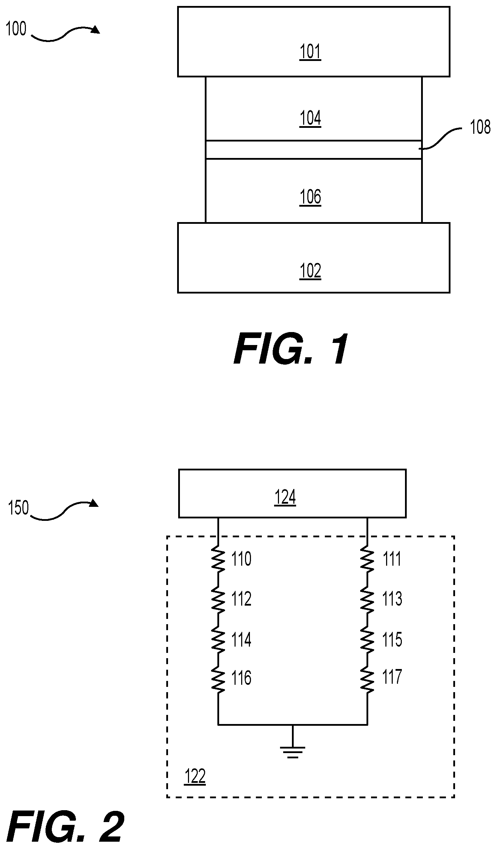

The magnetic tunnel junction (MTJ) 100 is a fundamental unit of a memory array. As shown in the diagram of FIG. 1, the MTJ 100 may include, among other things, two magnetic layers 104, 106 on opposite sides of an insulator 108. The two magnetic layers 104, 106 may include a fixed magnetic layer 106 (also known as the reference layer) with a fixed magnetic moment and a free layer 104 with a non-fixed magnetic moment. By changing the direction of the magnetic moment of the free layer 104, the logical state of the MTJ bit may be changed (also known as "programming" or "writing" the MTJ). An MTJ may also include top electrode 101, bottom electrode 102, as well as various other elements.

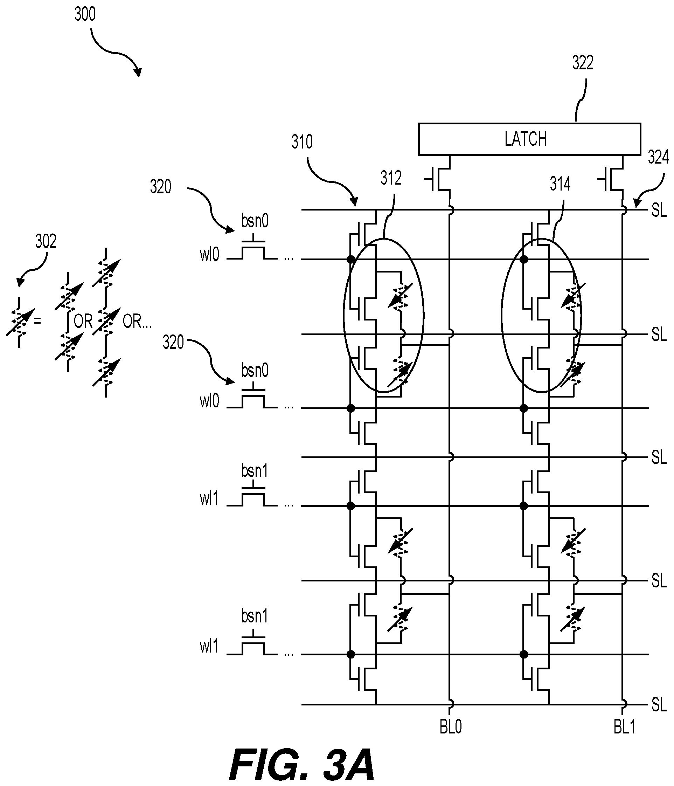

MTJ bits (such as those shown in FIGS. 3A, 4A, 5A, 6A, 7A, and 8A) may each include multiple MTJs 100 that are electrically connected together. The logical state of the MTJ bit may be based on the differences in polarities (e.g., states) of the individual MTJs 100 in an MTJ bit. An MTJ bit may be electrically connected to a read device, which reads the logical state of the MTJ bit based on the comparisons of the polarities between sets of MTJs 100 in the MTJ bit. Based on the results of that comparison, the read device will record a logical state corresponding to the logical state of the MTJ bit. Performance can be improved by including more MTJ bits on each integrated circuit chip.

FIG.2 depicts a diagram of an existing memory design 150 that includes a number of MTJs 110, 111, 112, 113, 114, 115, 116, 117 and a sense-amp latch 124 for every magnetic tunnel junction (MTJ) network 112. Dedicating an MTJ network 122 for each latch 124 in a circuit may provide parallel read-out with fast start-up. As described in U.S. Patent Application Number 18/590,543 and U.S. Patent Application Number 17/893,462 (both of which are herein fully incorporated by reference in their entireties), distributing the MTJ network 122 with a select device can improve the area required for a given density in some applications.

Embodiments of the present disclosure describe, at a device- or transistor-level, how to implement, *e.g.,* selected bank clusters (*e.g.,* the bank clusters described in U.S. Patent Application Number 18/590,543). Embodiments of this disclosure improves area efficiency of, *e.g.,* power-gated, distributed MRAM by sharing read (also known as "sense") and/or program (also known as "write") circuits with more than one memory (e.g., MRAM) network. Such embodiments maintain advantages, such as a dedicated latch, and include a fast (*e.g.,* less than 10 ns) start-up so that the memory can be power-gated but respond to access requests quickly. In such embodiments, there is no requirement for dedicated analog bias. Additionally, multiple MTJs may be included in differential configurations for robust and varied operation.

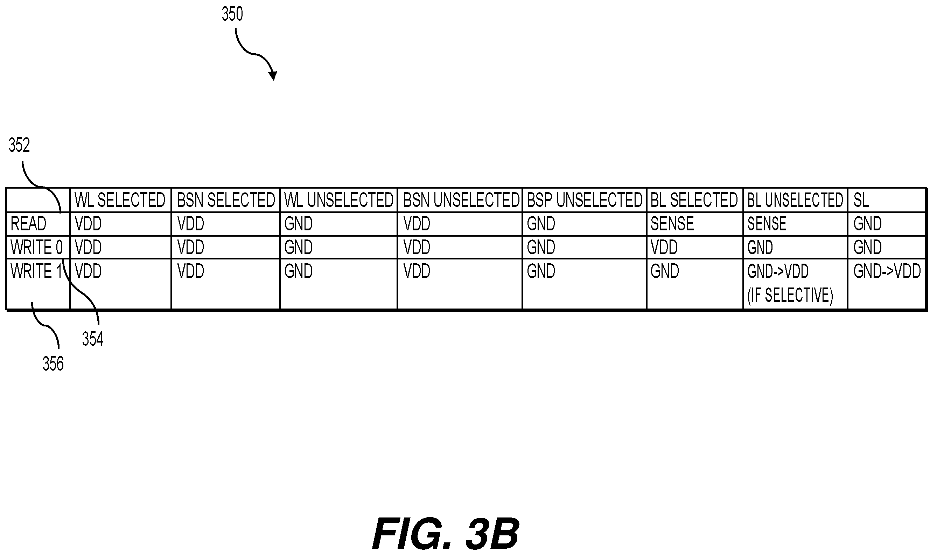

With reference now to FIG. 3A, an exemplary memory device 300 including an MTJ bit 310 is depicted according to a first embodiment. FIG. 3B depicts a table 350 showing the electrical configuration of the memory device 300 shown in FIG. 3A for read and write operations. The table 350 represents a read operation in row 352, a first write operation ("write 0") in row 354, and a second write operation ("write 1") in row 356 with corresponding operations in each column.

The MTJ bit 310 may include a first MTJ array 312 and a second MTJ 314 array which may include a number of MTJs 302. The exemplary memory device 300 may also include a read device (latch) 322. Notably, FIG. 3A shows MTJs 302 of the first and second arrays 312, 314 in parallel between adjacent rows with an n-type metal oxide semiconductor (NMOS) bank. MTJs 302 in adjacent rows (same column) may have a first polarity (i.e., may have the same polarity) and are sensed electrically in parallel. "Polarity," as used herein, refers to the direction of the magnetic moment of a free layer (such as layer 104 in FIG. 1) relative to the direction of a magnetic moment of a fixed layer (such as layer 106 in FIG. 1) within each MTJ 302. The direction may be, for example, parallel (when the directions are the same) or antiparallel (when the directions are opposite). MTJs 302 in adjacent columns (same row) may have opposite polarities. Although MTJs 302 are illustrated in FIG. 3A as single MTJs 302 for simplicity, a single MTJ symbol may represent multiple MTJs 302 in series. For the write operation 352 (referred to as "write1" in the Table 350 of FIG. 3B), a boot strap transistor 320 allows the supply overdrive gate voltage to NMOS transistor select devices to adjust as voltage is applied to the source and drain of the select gate devices. The memory device 300 may include any number of transistors. If required for boot strap consistency in one write operation, all MTJs 302 in a row may be written to one polarity, then selectively written to the other polarity. In this embodiment, MTJ groups of two opposite polarities are employed. Note that in other embodiments any of the MTJ groups may be replaced by resistor or any resistance implemented with active devices such as transistor. In such embodiments, only one MTJ group is employed.

In the exemplary memory device 300, the source line 324 ("SL" in FIGS. 3A and 3B) may be oriented vertically (not shown in FIG. 3A) or horizontally (shown in FIG. 3A). By configuring the memory device in this way, no well breaks are inside the MTJ array(s) 312, 314, thereby reducing the amount of layout area the memory device 300 occupies. That is, the current embodiment amortizes both the read and write circuitries. Moreover, all MTJs 302 in a network (or set) may be written or read simultaneously, and may share a current. The memory device 300 may include a read device 322 (labeled as a "latch" in FIG. 3A) electrically connected to the first MTJ array 312 and the second MTJ array 314. In some implementations, the array circuitry of the memory device 300 may receive power only during read and write operations (e.g., the array circuit may be powered off between operations on the MTJ bit 310 by the read and/or write circuitries), and may be powered off once a state of the MTJ bit 310 is recorded by the read device.

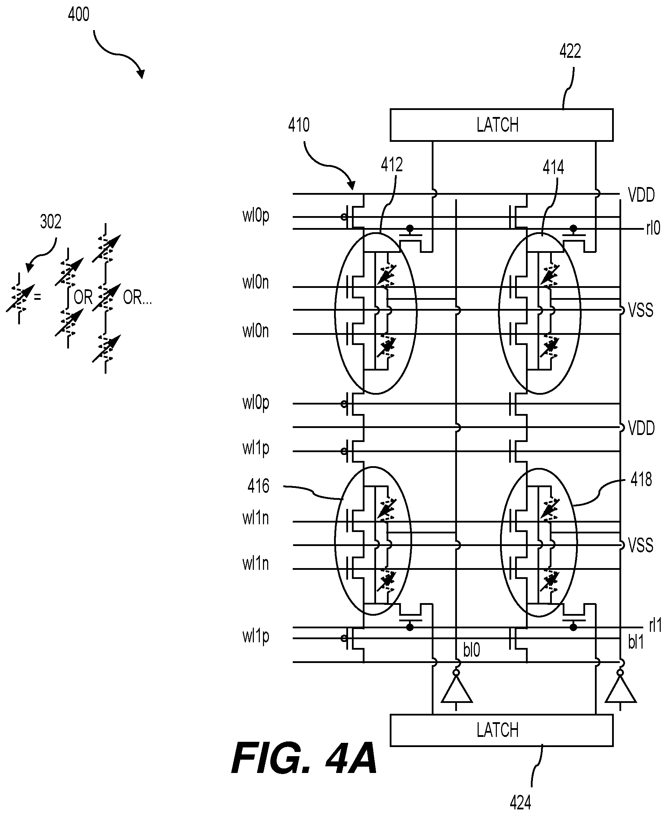

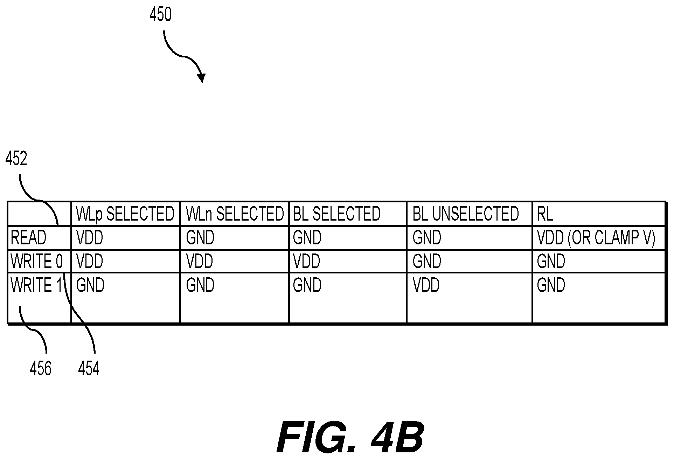

With reference now to FIG. 4A, an exemplary memory device 400 including an MTJ bit 410 is depicted according to a second embodiment. The exemplary memory device 400 may include first, second, third, and fourth MTJ arrays 412, 414, 416, 418, respectively. FIG. 4B depicts a table 450 showing the electrical configuration of the memory device 400 shown in FIG. 4A for read and write operations. The table 450 represents a read operation in row 452, a first write operation ("write 0") in row 454, and a second write operation ("write 1") in row 456 with corresponding operations in each column.

The memory device 400 in FIG. 4A may include a first read device 422 and an additional read device 424 (also referred to as "second read device") connected to third and fourth MTJ arrays 416, 418, in addition to a first read device connected to the first and second MTJ arrays 412, 414. The memory device 400 may include write circuitry that includes both n-type metal oxide semiconductor (NMOS) transistors and p-type metal oxide semiconductor (NMOS) transistors. Notably, FIG. 4A shows third and fourth MTJ arrays 416, 418 in parallel with an option for a distributed latch (*i.e.,* second read device 424). Similar to FIG. 3A, although MTJs 302 are illustrated as single MTJs 302 for simplicity, a single MTJ symbol may represent multiple MTJs 302 in series. In some embodiments, the second read device 424 is substantially similar or even the same as the first read device 422. Specifically, MTJs 302 in adjacent rows (*i.e.,* same column) may have the first polarity (i.e., may have the same polarity) and sensed in electrically parallel configuration, whereas MTJs 302 in adjacent columns (same row) may have opposite polarities. NMOS on read lines (referred to as "rl0" and "rl1" in FIG. 4A and "RL" in FIG. 4B) may function as a read device 422, 424 (*e.g.,* a latch clamp device). The latch may be either common to the bank (*i.e.,* sense one row at a time) or distributed to each pair (as shown, parallel read-out of all bits). Such an implementation may use a combination of PMOS/NMOS transistors as the write circuitry, but may also implement using an NMOS-only boot-strapped array, as shown in FIG. 3A. By sharing the latch 422, 424 between MTJ arrays 412, 414, 416, 418 in the memory device 400, the write circuitry is amortized in the case where the latch 422, 424 remains dedicated to a differential network of MTJs. In some implementations, the array circuitry of the memory device 400 may receive power only during read and write operations (*e.g.,* the array circuit may be powered off between operations on the MTJ bit 410 by the read and/or write circuitries), and may be powered off once a state of the MTJ bit 410 is recorded by the read device 422, 424.

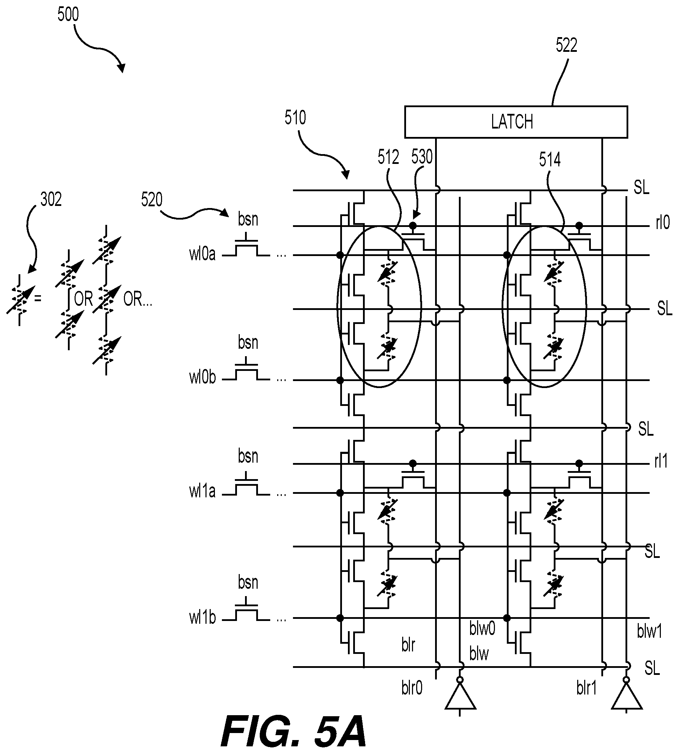

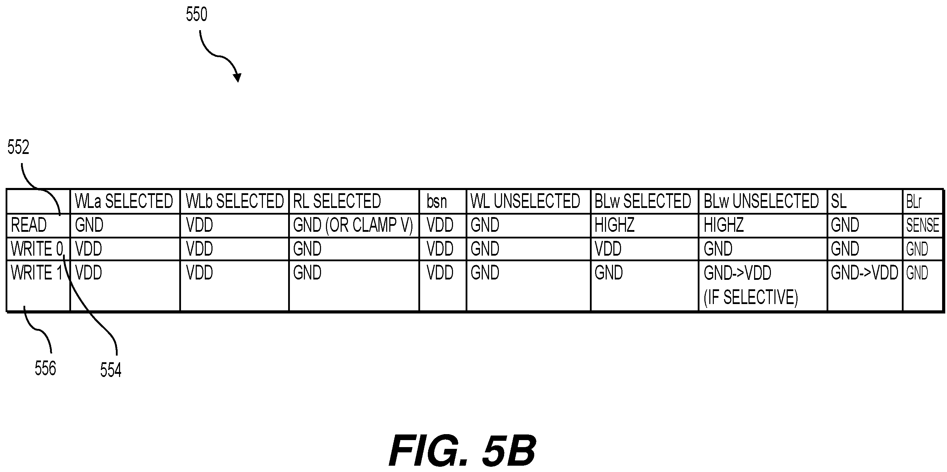

With reference now to FIG. 5A, an exemplary memory device 500 including an MTJ bit 510 is depicted according to a third embodiment. The memory device 500 may have some similarities to memory devices in other embodiments of the disclosure, including having MTJs 302 in adjacent rows (same column) that may have a first polarity (i.e., may have the same polarity) and sensed electrically in series, and MTJs 302 in adjacent columns (same row) that may have opposite polarities. FIG. 5B depicts a table 550 showing the electrical configuration of the memory device 500 shown in FIG. 5A for read and write operations. The table 550 represents a read operation in row 552, a first write operation ("write 0") in row 554, and a second write operation ("write 1") in row 556 with corresponding operations in each column.

Notably, FIG. 5A shows MTJs 302 in series between adjacent rows with an NMOS bank. Clamp devices 530 (e.g., the NMOS transistors having their gates connected to the respective read lines) for sensing may be placed inside the MTJ arrays 512, 514. For the write1 operation, the boot strap transistor 520 allows the supply overdrive to NMOS select devices. Similar to FIG. 4A, although MTJs 302 are illustrated as single MTJs 302 for simplicity, a single MTJ symbol may represent multiple MTJs 302 in series. In some implementations, the array circuitry of the memory device 500 may receive power only during read and write operations (e.g., the array circuit may be powered off between operations on the MTJ bit 510 by the read and/or write circuitries), and may be powered off once a state of the MTJ bit 510 is recorded by the read device 522.

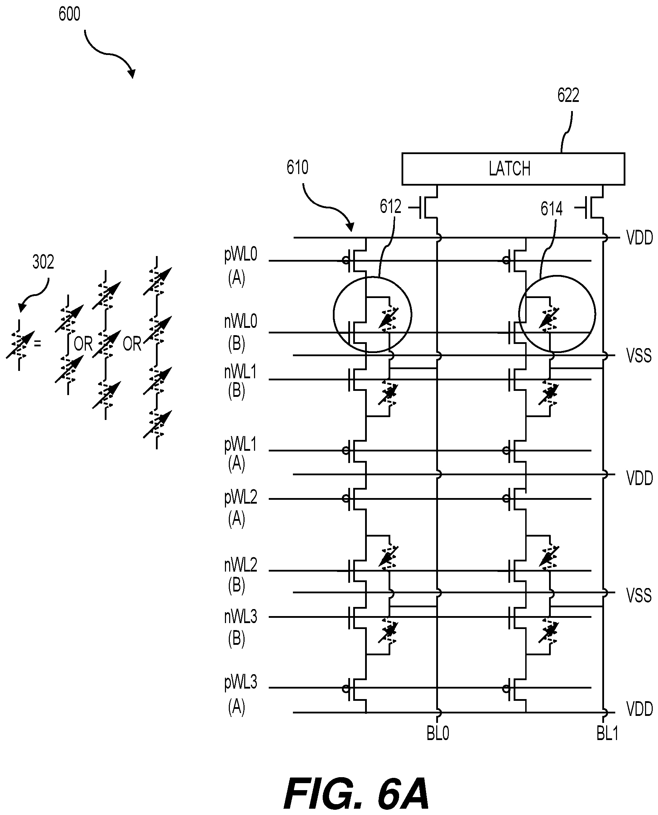

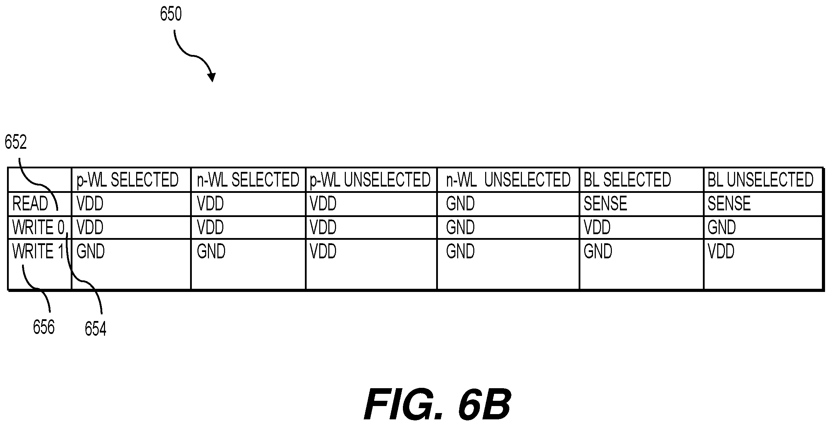

With reference now to FIG. 6A, an exemplary memory device 600 including an MTJ bit 610 is depicted according to a fourth embodiment. In the memory device 600, MTJs 302 in a same leg may be programmed all at once, or simultaneously. FIG. 6B depicts a table 650 showing the electrical configuration of the memory device 600 shown in FIG. 6A for read and write operations. The table 650 represents a read operation in row 652, a first write operation ("write 0") in row 654, and a second write operation ("write 1") in row 656 with corresponding operations in each column.

In the memory device 600, the "A" lines (*e.g.,* pWL0 - pWL3) and "B" lines (e.g., nWL0 - nWL3) may be activated to program polarities of the MTJs 302 in the MTJ arrays 612, 614, with bit-line voltage set to either the program bit on the column, or to an inhibit configuration. A two-pass operation may program bits to either high or low. Inhibited rows are set to high-z ("A" WL at VDD/"B" WL at ground). Such a configuration may require that either two MTJs 302 in series be sufficient, or the multiple MTJs 302 may be programed together in series. MTJs 302 on the same row in adjacent columns (circled) may be programmed to opposite polarities. The read operation for a given set of MTJs 302 in a row may be selected (indicated by a "B" WL to VDD), with the remaining MTJs 302 in the memory device being set to WLs at inhibit voltage. Similar to FIG. 5A, although MTJs 302 are illustrated as single MTJs 302 for simplicity, a single MTJ symbol may represent multiple MTJs 302 in series. In some implementations, the array circuitry of the memory device 600 may receive power only during read and write operations (*e.g.,* the array circuit may be powered off between operations on the MTJ bit 610 by the read and/or write circuitries), and may be powered off once a state of the MTJ bit 610 is recorded by the read device 622.

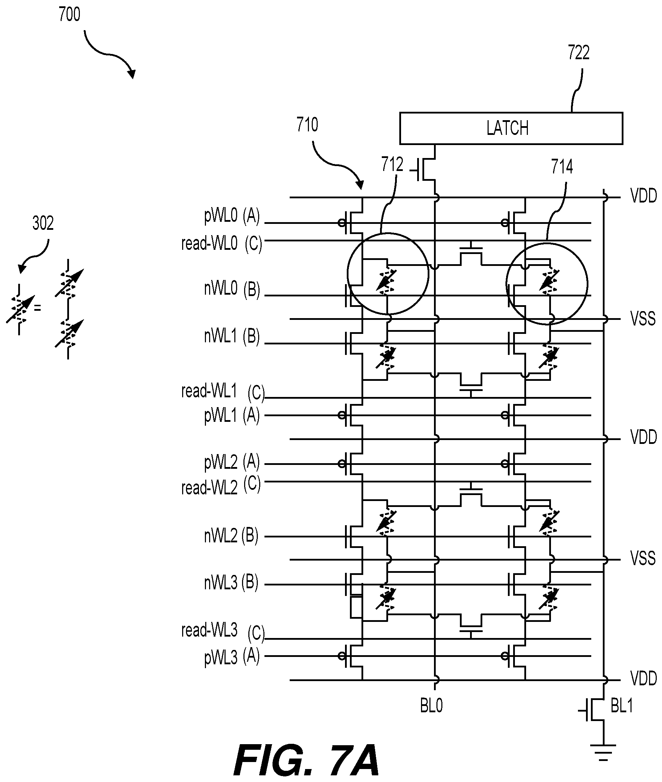

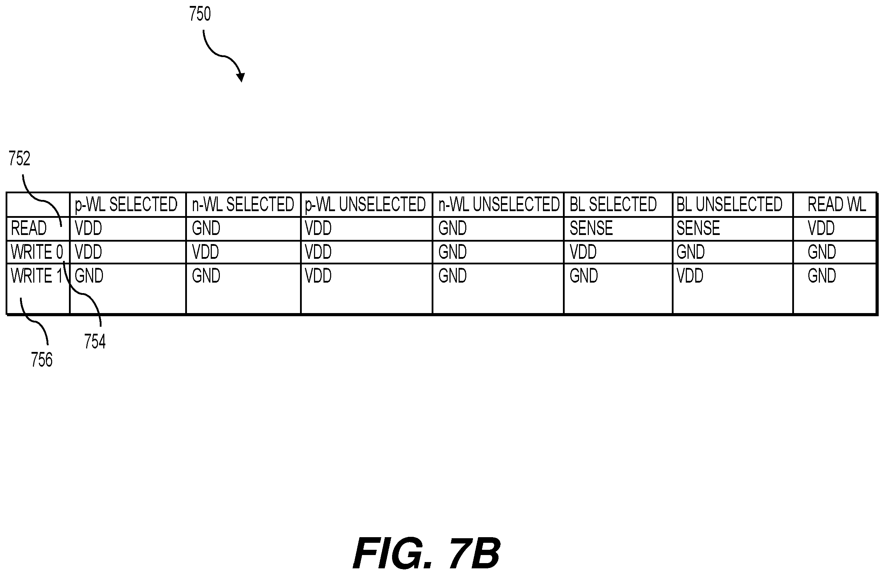

With reference now to FIG. 7A, an exemplary memory device 700 including an MTJ bit 710 is depicted according to a fifth embodiment. In the memory device 700, MTJs 302 in arrays 712, 714 on the same row but in adjacent columns are programmed to a first polarity (i.e., programmed to the same polarity), while adjacent pairs (*e.g.,* in a four-column unit) are programmed to a second polarity opposite the first polarity. FIG. 7B depicts a table 750 showing the electrical configuration of the memory device 700 shown in FIG. 7A for read and write operations. The table 750 represents a read operation in row 752, a first write operation ("write 0") in row 754, and a second write operation ("write 1") in row 756 with corresponding operations in each column.

In the memory device 700 shown in FIG. 7A, although only two columns are illustrated for simplicity, any number of additional columns may be present. For example, the memory device 700 may include two more columns connected to the read device (latch) 722, achieving a four-column unit. Programming may be accomplished in similar manner to the embodiment described in FIG. 6A including "A" lines (*e.g.,* pWL0 - pWL3) and "B" lines (e.g., nWL0 - nWL3), with the addition of "C" WL (*e.g.,* read-WL0 - read-WL3) set to inhibit (e.g., ground). Similar to FIG. 6A, although MTJs 302 are illustrated as single MTJs 302 for simplicity, a single MTJ symbol may represent multiple MTJs 302 in series. In some implementations, the array circuitry of the memory device 700 may receive power only during read and write operations (e.g., the array circuit may be powered off between operations on the MTJ bit 710 by the read and/or write circuitries), and may be powered off once a state of the MTJ bit 710 is recorded by the read device 722. The read operation may activate a single "C" WL to connect an adjacent WL. The read operation may sense current into one adjacent BL, with the other BL set to ground.

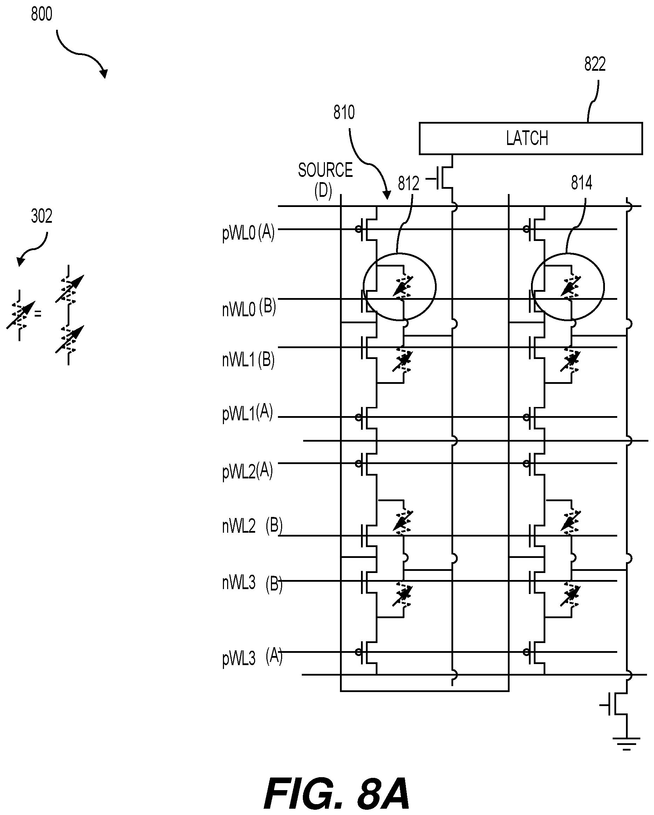

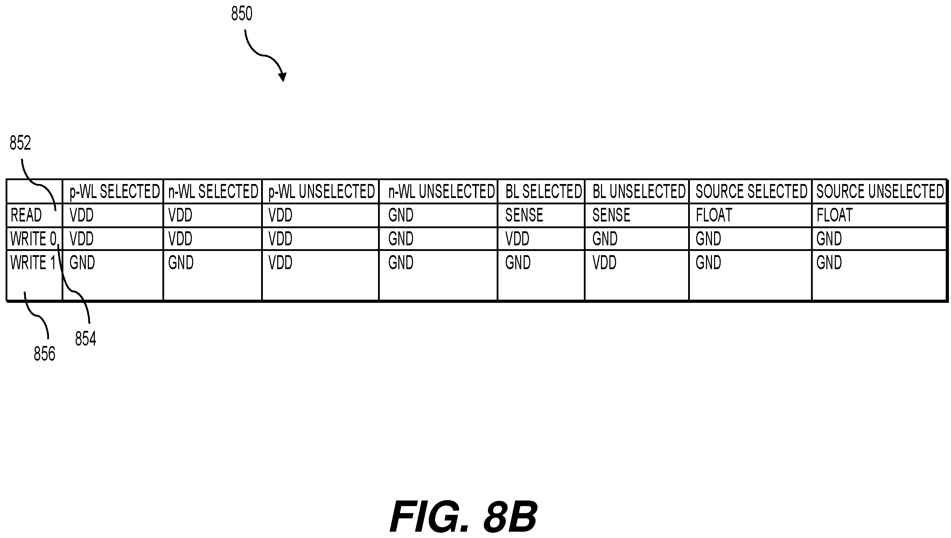

With reference now to FIG. 8A, an exemplary memory device 800 including an MTJ bit 810 is depicted according to a sixth embodiment. In the memory device 800, MTJs 302 in arrays 812, 814 on the same row in adjacent columns may be programmed to a first polarity (i.e., may be programmed to the same polarity), while adjacent pairs (*e.g.,* in a four-column unit) may be programmed to a second polarity opposite the first polarity. Furthermore, the memory device 800 may include vertical "D" source lines (Source). FIG. 8B depicts a table 850 showing the electrical configuration of the memory device 800 shown in FIG. 8A for read and write operations. The table 850 represents a read operation in row 852, a first write operation ("write 0") in row 854, and a second write operation ("write 1") in row 856 with corresponding operations in each column.

Although only two columns are illustrated in FIG. 8A for simplicity, any number of additional columns may be present. For example, the memory device 800 may include two more columns connected to the read device (latch) 822, to achieve a 4-column unit. Programming may be done as described in the fifth embodiment shown in FIG. 7A, with "D" source lines (Source) set to ground. Similar to FIG. 7A, although MTJs 302 are illustrated as single MTJs 302 for simplicity, a single MTJ symbol may represent multiple MTJs 302 in series. In some implementations, the array circuitry of the memory device 800 may receive power only during read and write operations (*e.g.,* the array circuit may be powered off between operations on the MTJ bit 810 by the read and/or write circuitries), and may be powered off once a state of the MTJ bit 810 is recorded by the read device 822. During the read operation, the "D" source lines (Source) are not driven. Active "B" WL (e.g., nWL0 - nWL1) is set to VDD, while the remaining WLs are at inhibit. Current then flows through the pair of select NMOS and "D" SL (Source) to connect adjacent pair in series.

In general, any process or operation discussed in this disclosure that is understood to be computer-implementable, such as the flows and/or process discussed herein (e.g., in FIGS. 3A-8B), etc., may be performed by one or more processors of a computer system, such any systems or devices used to implement the techniques disclosed herein. A process or process step performed by one or more processors may also be referred to as an operation. The one or more processors may be configured to perform such processes by having access to instructions (e.g., software or computer-readable code) that, when executed by the one or more processors, cause the one or more processors to perform the processes. The instructions may be stored in a memory of the computer system. A processor may be a central processing unit (CPU), a graphics processing unit (GPU), or any suitable types of processing unit.

While principles of the present disclosure are described herein with reference to illustrative examples for particular applications, it should be understood that the disclosure is not limited thereto. For example, instead of a MTJ-based bitcell (e.g., configuration bit), another memory bit such as resistive RAM, Ferroelectric RAM, or Phase Change Memory (PCM) bit technology may be used to design the antifuse circuitry with the present disclosure. Another memory bit may have a programmed state and at least one unprogrammed state. The at least one unprogrammed state may further comprise a plurality of unprogrammed states, for example, a low unprogrammed state, a high unprogrammed state, and one or more intermediate unprogrammed states. Those having ordinary skill in the art and access to the teachings provided herein will recognize additional modifications, applications, embodiments, and substitution of equivalents all fall within the scope of the features described herein. Accordingly, the claimed features are not to be considered as limited by the foregoing description.

In one embodiment, the present disclosure is drawn to a memory device, which may include: an array circuit including a magnetic tunnel junction (MTJ) bit having a logical state, the array circuit including a set of MTJs; a first read device electrically connected to the MTJ bit and configured to read the logical state of the MTJ bit; and a write circuit electrically connected to the MTJ bit, the write circuit configured to write the logical state of the MTJ bit, wherein the array circuit is powered off between operations on the MTJ bit by the first read device, the write circuit, or both the first read device and the write circuit.

The set of MTJs may include a first MTJ array having a first polarity and a second MTJ array having a second polarity opposite the first polarity. The set of MTJs may include a first MTJ array having a first polarity and a second MTJ array having a second polarity opposite the first polarity, wherein the read device reads the first polarity of the first MTJ array or the second polarity of the second MTJ array in one of series, parallel, or a combination thereof. The set of MTJs may include a first MTJ array and a second MTJ array, wherein at least one of the first MTJ array or the second MTJ array comprises a clamp device. The write circuit may include a boot strap circuit and/ or an n-type metal-oxide semiconductor transistor. The memory device may also include a second read device that is electrically connected to an additional MTJ bit including an additional set of MTJs, the additional set of MTJs comprising a third MTJ array and a fourth MTJ array, wherein the second read device is configured to read the logical state of the additional MTJ bit. The array circuit may be powered off between read operations on the MTJ bit by the read device.

In another embodiment, the present disclosure is drawn to a memory device, which may include: an array circuit including a magnetic tunnel junction (MTJ) bit having a logical state, the MTJ bit including a first array of at least two MTJs having a first polarity and a second array of at least two MTJs having a second polarity opposite the first polarity; a read device configured to read the first polarity of the at least two MTJs of the first array and the second polarity of the at least two MTJs of the second array; and a write circuit electrically connected to the MTJ bit, wherein the write circuit is configured to program the MTJs in the first array and the second array, wherein the array circuit is configured to be powered off between read operations on the MTJ bit by the read device.

The read device may be configured to read the second polarity of the at least two MTJs of the second array simultaneously with the first polarity of the at least two MTJs of the first array. The read device may be configured to read the second polarity of the at least two MTJs of the second array in series with the first polarity of the at least two MTJs of the first array. The write circuit may be configured to program the MTJs in the first array and the second array simultaneously. At least one of the first array and the second array may include a clamp device. The write circuit may include a boot strap circuit and/or an n-type metal-oxide semiconductor transistor.

In yet another embodiment, the present disclosure is drawn to a memory device, which may include: an array circuit including a magnetic tunnel junction (MTJ) bit having a logical state, the MTJ bit including: a first MTJ array; a second MTJ array; a third MTJ array; and a fourth MTJ array, wherein the first and second MTJ arrays have a first polarity and the third and fourth MTJ arrays have a second polarity opposite the first polarity; a read circuit electrically connected to the MTJ bit and configured to read the logical state of the MTJ bit; and a write circuit electrically connected to the MTJ bit, wherein the array circuit is configured to be powered off between read operations on the MTJ bit by the read device.

The read circuit may be configured to read the first polarity of the first and second MTJ arrays simultaneously with the second polarity of the third and fourth MTJ arrays. The read circuit may be configured to read the first polarity of the first and second MTJ arrays in series with the second polarity of the third and fourth MTJ arrays. At least one of the first, second, third, or fourth MTJ arrays may include a clamp device. The first and second MTJ arrays may be electrically connected in series, and the third and fourth MTJ arrays may be electrically connected in series.

The foregoing description of the inventions has been described for purposes of clarity and understanding. It is not intended to limit the inventions to the precise form disclosed. Various modifications may be possible within the scope and equivalence of the application.

## Claims

1. A memory device, comprising:
an array circuit including a magnetic tunnel junction (MTJ) bit having a logical state, the array circuit including a set of MTJs;
a first read device electrically connected to the MTJ bit and configured to read the logical state of the MTJ bit; and
a write circuit electrically connected to the MTJ bit, the write circuit configured to write the logical state of the MTJ bit,
wherein the array circuit is powered off between operations on the MTJ bit by the first read device, the write circuit, or both the first read device and the write circuit.

2. The memory device of claim 1, wherein the set of MTJs comprises a first MTJ array having a first polarity and a second MTJ array having a second polarity opposite the first polarity.

3. The memory device of claim 2, wherein the read device reads the first polarity of the first MTJ array or the second polarity of the second MTJ array in one of series, parallel, or a combination thereof.

4. The memory device of one of the preceding claims, wherein the set of MTJs comprises a first MTJ array and a second MTJ array, wherein at least one of the first MTJ array or the second MTJ array comprises a clamp device.

5. The memory device of one of the preceding claims, further comprising a second read device that is electrically connected to an additional MTJ bit including an additional set of MTJs, the additional set of MTJs comprising a third MTJ array and a fourth MTJ array, wherein the second read device is configured to read the logical state of the additional MTJ bit.

6. The memory device of one of the preceding claims, wherein the array circuit is powered off between read operations on the MTJ bit by the read device.

7. A memory device, comprising:
an array circuit including a magnetic tunnel junction (MTJ) bit having a logical state, the MTJ bit including a first array of at least two MTJs having a first polarity and a second array of at least two MTJs having a second polarity opposite the first polarity;
a read device configured to read the first polarity of the at least two MTJs of the first array and the second polarity of the at least two MTJs of the second array; and
a write circuit electrically connected to the MTJ bit, wherein the write circuit is configured to program the MTJs in the first array and the second array,
wherein the array circuit is configured to be powered off between read operations on the MTJ bit by the read device.

8. The memory device of claim 7, wherein the read device is configured to read the second polarity of the at least two MTJs of the second array simultaneously with the first polarity of the at least two MTJs of the first array, or in series with the first polarity of the at least two MTJs of the first array.

9. The memory device of claim 7 or 8, wherein the write circuit is configured to program the MTJs in the first array and the second array simultaneously.

10. The memory device of one of claims 7 to 9, wherein at least one of the first array or the second array comprises a clamp device.

11. The memory device of one of the preceding claims, wherein the write circuit includes a boot strap circuit and/or an n-type metal-oxide semiconductor transistor.

12. A memory device, comprising:
an array circuit including a magnetic tunnel junction (MTJ) bit having a logical state, the MTJ bit including:
a first MTJ array;
a second MTJ array
a third MTJ array; and
a fourth MTJ array,
wherein the first and second MTJ arrays have a first polarity and the third and fourth MTJ arrays have a second polarity opposite the first polarity;
a read circuit electrically connected to the MTJ bit and configured to read the logical state of the MTJ bit; and
a write circuit electrically connected to the MTJ bit,
wherein the array circuit is configured to be powered off between read operations on the MTJ bit by the read device.

13. The memory device of claim 12, wherein the read circuit is configured to read the first polarity of the first and second MTJ arrays simultaneously with the second polarity of the third and fourth MTJ arrays or in series with the second polarity of the third and fourth MTJ arrays.

14. The memory device of claim 12 or 13, wherein at least one of the first, second, third, or fourth MTJ arrays comprises a clamp device.

15. The memory device of one of claims 12 to 14, wherein the first and second MTJ arrays are electrically connected in series, and wherein the third and fourth MTJ arrays are electrically connected in series.
